(19) Europäisches Patentamt
European Patent Office
Office européen des brevets

(11) **EP 4 234 313 A1**

(12) **EUROPEAN PATENT APPLICATION**

(43) Date of publication:
**30.08.2023 Bulletin 2023/35**

(21) Application number: **22205612.9**

(22) Date of filing: **04.11.2022**

(51) International Patent Classification (IPC):
**B60L 53/62** (2019.01)  **B60L 53/65** (2019.01)
**B60L 53/68** (2019.01)  **B60L 58/13** (2019.01)
**B60L 3/00** (2019.01)

(52) Cooperative Patent Classification (CPC):
**B60L 53/62; B60L 3/0046; B60L 53/65;**
**B60L 53/68; B60L 58/13;** B60L 2240/70;
B60L 2260/54; Y02T 90/167

(84) Designated Contracting States:
**AL AT BE BG CH CY CZ DE DK EE ES FI FR GB**
**GR HR HU IE IS IT LI LT LU LV MC ME MK MT NL**
**NO PL PT RO RS SE SI SK SM TR**
Designated Extension States:
**BA**
Designated Validation States:
**KH MA MD TN**

(30) Priority: **23.02.2022 CN 202210167156**

(71) Applicant: **Autel New Energy Co., Ltd.**
**Shenzhen 518055 (CN)**

(72) Inventor: **Shen, Xiaojie**
**Shenzhen, 518055 (CN)**

(74) Representative: **Gulde & Partner**
**Patent- und Rechtsanwaltskanzlei mbB**
**Wallstraße 58/59**
**10179 Berlin (DE)**

(54) **METHOD FOR ACQUIRING AND SETTING CHARGING CUT-OFF QUANTITY, AND CHARGING MANAGEMENT SYSTEM**

(57) The embodiments of the present invention relate to the technical field of battery charging control, and disclose a method for acquiring and setting a charging cut-off quantity, and a charging management system. In the system, a cloud server is communicatively connected to a charging apparatus, and the charging apparatus is communicatively connected to a new energy vehicle. The cloud server can acquire and invoke battery history data of the new energy vehicle according to a charging request of the charging apparatus for a power battery of the new energy vehicle, so as to calculate and obtain the charging cut-off quantity of the charging apparatus for the power battery, and send the charging cut-off quantity to the charging apparatus. The charging apparatus can perform charging and electric quantity monitoring on the power battery according to the charging cut-off quantity. The method provided by the embodiments of the present invention realizes intelligent calculation and setting of the charging cut-off quantity, which can effectively improve the power consumption and charging safety of the new energy vehicle, prolong the service life of the battery and reduce the driving safety risk of the user.

Receiving a charging request from the charging apparatus for a power battery of the new energy vehicle — S110

Invoking battery history data of the new energy vehicle according to the charging request, wherein the battery history data is obtained by the cloud server acquiring battery usage data of the new energy vehicle and processing the battery usage data — S120

Calculating a charging cut-off quantity of the power battery charged by the charging apparatus according to the battery history data — S130

Sending the charging cut-off quantity to the charging apparatus so that the charging apparatus charges the power battery of the new energy vehicle and detects that a battery state of charge of the power battery of the new energy vehicle reaches the charging cut-off quantity — S140

Fig. 2

EP 4 234 313 A1

## Description

## Technical Field

The present application relates to the technical field of battery charging control, and particularly relates to a method for acquiring and setting a charging cut-off quantity and a charging management system.

## Background Art

Under the background of global energy diversification development strategy, after years of technical precipitation, new energy vehicles with power batteries as main energy storage devices and their associated charging facilities are being accepted by more and more consumers, and the number of new energy vehicles is increasing. Compared with traditional gas stations, the safety factor of charging facilities for new energy vehicles is higher. Most of the charging process can be completed by vehicle owners themselves. The construction threshold of charging facilities is relatively low. With the popularization of domestic charging apparatus, residential charging stations, large charging stations and other charging infrastructure, the frequency of daily charging operations for vehicle owners is gradually increasing.

In carrying out embodiments of the present invention, the inventors have found that the above related art has at least the following problems.

Generally, the owner of the vehicle conventionally fills the power battery every charge. However, the battery with a high capacity for a long period of time has a large internal energy, and the consumption of the electrolyte active material is accelerated, resulting in an accelerated decline in the service life of the battery. More seriously, the electrolyte of the battery decomposes to generate gas, which causes the battery to expand, and finally causes the battery to burn and explode. In news reports of deflagration accidents for new energy vehicles in recent years, more than sixty percent of accidents occur when the power battery is high.

At present, although some new energy vehicles and charging apparatus support the user to manually adjust the charging cut-off quantity, it is usually set as one or several fixed values in a "one-cut" manner since the owner of the vehicle generally does not know the characteristics of the power battery and cannot set the appropriate charging cut-off quantity. For long-term underfilled batteries, on the one hand, the balancing function of the battery management system at the vehicle side fails to work normally, the battery consistency deteriorates, and the mileage of the vehicle decays. On the other hand, the state of charge of the battery is difficult to be calibrated, the estimated accumulated error of the state of charge of the battery increases, and the vehicle meter displays the mileage incorrectly. Both of these aspects may cause the vehicle to suddenly lose power during driving, resulting in a safety accident.

## Summary of the Invention

The embodiments of the present application provide a method for acquiring and setting an appropriate charging cut-off quantity which can be intelligently calculated and set, a device thereof, and a charging management system.

The object of the embodiments of the present invention is achieved by the following technical solutions.

In order to solve the above-mentioned technical problem, in a first aspect, the embodiments of the present invention provide a method for acquiring a charging cut-off quantity, which is applied to a cloud server, wherein the cloud server is communicatively connected to a charging apparatus which is communicatively connected to a new energy vehicle, the method comprising: receiving a charging request from the charging apparatus for a power battery of the new energy vehicle; invoking battery history data of the new energy vehicle according to the charging request, wherein the battery history data is obtained by the cloud server acquiring battery usage data of the new energy vehicle and processing the battery usage data; calculating a charging cut-off quantity of the power battery charged by the charging apparatus according to the battery history data; and sending the charging cut-off quantity to the charging apparatus so that the charging apparatus charges the power battery of the new energy vehicle and detects that a battery state of charge (SOC) of the power battery of the new energy vehicle reaches the charging cut-off quantity.

In some embodiments, the calculating a charging cut-off quantity of the power battery charged by the charging apparatus according to the battery history data comprises: determining an upper limit value for the charging quantity according to the battery history data; determining a prediction value for the charging cut-off quantity according to the battery history data; and determining the charging cut-off quantity to be a smaller one of the upper limit value for the charging quantity and the prediction value for the charging cut-off quantity.

In some embodiments, the determining an upper limit value for the charging quantity according to the battery history data comprises: determining a battery safety failure level of the power battery based on the battery history data; and determining an upper limit value for the charging quantity of the power battery charged by the charging apparatus according to the battery safety failure level.

In some embodiments, the determining an upper limit value for the charging quantity of the power battery charged by the charging apparatus according to the battery safety failure level comprises: determining battery consistency or battery state of charge errors for the power battery of the new energy vehicle when the battery safety failure level has no safety risk; judging whether the power battery satisfies a full condition according to the battery consistency or the battery state of charge errors; if so, determining that the upper limit value for the charging quantity is a first upper limit value; and if not, determining that the upper limit value for the charging quantity is a second upper limit value, wherein the second upper limit value is less than the first upper limit value.

In some embodiments, the determining a prediction value for the charging cut-off quantity according to the battery history data comprises: determining an electricity consumption prediction value, an electricity consumption lower limit value and an electricity consumption lower limit threshold value after the power battery is charged according to the battery history data; and determining the prediction value for the charging cut-off quantity according to the electricity consumption prediction value, the electricity consumption lower limit value and the electricity consumption lower limit threshold value after the power battery is charged.

In some embodiments, the determining an electricity consumption prediction value, an electricity consumption lower limit value and an electricity consumption lower limit threshold value after the power battery is charged according to the battery history data comprises: determining the electricity consumption prediction value and the electricity consumption lower limit threshold value according to the battery history data and the environment data of the power battery use environment.

In some embodiments, the determining the prediction value for the charging cut-off quantity according to the electricity consumption prediction value, the electricity consumption lower limit value and the electricity consumption lower limit threshold value after the power battery is charged has a calculation formula as follows:

$$SOC_{pre} = k_1 SOC_{window} + SOC_{lower} + k_2 SOC_{buffer}$$

where $SOC_{pre}$ represents a prediction value for the charging cut-off quantity; $SOC_{window}$ represents an electricity consumption prediction value; $SOC_{lower}$ represents an electricity consumption lower limit value; $SOC_{buffer}$ represents an electricity consumption lower limit threshold value; $k_1$ represents a low-temperature coefficient for the electricity consumption prediction value; and $k_2$ represents a low-temperature coefficient for the electricity consumption lower limit threshold value.

In order to solve the above-mentioned technical problem, in a second aspect, the embodiments of the present invention provide a method for setting a charging cut-off quantity, which is applied to a charging apparatus, wherein the charging apparatus is communicatively connected to a cloud server, and the charging apparatus is electrically connected to a new energy vehicle, the method comprising: sending a charging request for a power battery of the new energy vehicle to the cloud server, so that the cloud server invokes battery history data of the new energy vehicle according to the charging request, wherein the battery history data is obtained by the cloud server acquiring battery usage data of the new energy vehicle and processing the battery usage data; receiving a charging cut-off quantity of the power battery sent by the cloud server, wherein the charging cut-off quantity is calculated by the cloud server according to the battery history data; and charging the power battery of the new energy vehicle and detecting that a battery state of charge of the power battery of the new energy vehicle reaches the charging cut-off quantity.

In order to solve the above technical problem, in a third aspect, the present invention provides a cloud server, comprising: at least one processor, and a storage communicatively coupled to the at least one processor, wherein the storage stores instructions executable by the at least one processor, the instructions being executable by the at least one processor to enable the at least one processor to perform the method of the first aspect.

To solve the above technical problem, in a fourth aspect, the embodiments of the present invention also provide a computer-readable storage medium storing computer-executable instructions for causing a computer to perform the method of the first aspect.

To solve the above technical problem, in a fifth aspect, the embodiments of the present invention also provide a computer program product including a computer program stored on a computer-readable storage medium, the computer program including program instructions which, when executed by a computer, cause the computer to perform the method according to the first aspect above.

In order to solve the above technical problem, in a sixth aspect of the present invention, the embodiments of the present invention provide a charging apparatus comprising: at least one processor, and a storage communicatively coupled to the at least one processor, wherein the storage stores instructions executable by the at least one processor, the instructions being executable by the at least one processor to enable the at least one processor to perform the method of the second aspect.

To solve the above technical problem, in a seventh aspect, the embodiments of the present invention provide a computer-readable storage medium storing computer-executable instructions for causing a computer to perform the method of the second aspect.

To solve the above technical problem, in an eighth aspect, the embodiments of the present invention also provide a computer program product including a computer program stored on a computer-readable storage medium, the computer program including program instructions which, when executed by a computer, cause the computer to perform the method according to the second aspect.

In order to solve the above technical problem, in a ninth aspect, the embodiments of the present invention also provide a charging management system, comprising: the cloud server in the third aspect configured for calculating and acquiring a charging cut-off quantity of a power battery; the charging apparatus in the fourth aspect, which is communicatively connected to the cloud server and electrically connected to a new energy vehicle, configured for charging a power battery of the new energy vehicle according to the charging cut-off quantity calculated by the cloud server and detecting that a battery state of charge (SOC) of the power battery of the new energy vehicle reaches the charging cut-off quantity.

Compared to the prior art, the advantageous effects of the present invention are as follows. Different from the prior art, the embodiments of the present invention provide a method for acquiring and setting a charging cut-off quantity, and a charging management system. In the system, a cloud server is communicatively connected to a charging apparatus, and the charging apparatus is communicatively connected to a new energy vehicle. The cloud server can acquire and invoke battery history data of the new energy vehicle according to a charging request of the charging apparatus for a power battery of the new energy vehicle, so as to calculate and obtain the charging cut-off quantity of the power battery charged by the charging apparatus, and send the charging cut-off quantity to the charging apparatus. The charging apparatus can perform charging and electric quantity monitoring on the power battery according to the charging cut-off quantity. The method provided by the embodiments of the present invention realizes intelligent calculation and setting of the charging cut-off quantity, which can effectively improve the power consumption and charging safety of the new energy vehicle, prolong the service life of the battery and reduce the driving safety risk of the user.

**Brief Description of the Drawings**

The one or more embodiments are exemplified by the pictures in the accompanying drawings corresponding to them. The illustrative description does not constitute a limitation for embodiments. Those elements/modules and steps with the same reference numerals in the accompanying drawings are represented as similar elements/modules and steps, and the figures in the accompanying drawings are not drawn to scale unless specifically stated.

Fig. 1 is a schematic view showing one application environment of a method for acquiring and setting a charging cut-off quantity according to an embodiment of the present invention;
Fig. 2 is a schematic flow chart of a method for acquiring a charging cut-off quantity according to Embodiment I of the present invention;
Fig. 3 is a sub-flow diagram of step S130 in the acquiring method shown in Fig. 2;
Fig. 4 is a sub-flow diagram of step S131 in the acquiring method shown in Fig. 3;
Fig. 5 is a sub-flow diagram of step S132 in the acquiring method shown in Fig. 3;
Fig. 6 is a flow diagram of a method for setting a charging cut-off quantity according to Embodiment II of the present invention;
Fig. 7 is a structurally schematic view of a charging cut-off quantity adjusting device according to Embodiment III of the present invention;
Fig. 8 is a structurally schematic view of a charging cut-off quantity adjusting device according to Embodiment IV of the present invention;
Fig. 9 is a schematic diagram of a hardware structure of a cloud server according to Embodiment V of the present invention;
Fig. 10 is a structurally schematic view of a hardware of a charging apparatus according to Embodiment VI of the present invention;
Fig. 11 is a structurally schematic view of a charging management system according to Embodiment VII of the present invention.

**Detailed Description of the Invention**

Hereinafter, the present invention will be described in detail with reference to specific embodiments. The following embodiments will aid those skilled in the art in further understanding of the present invention, but do not limit the invention in any way. It should be noted that several variations and modifications can be made by a person skilled in the art without departing from the inventive concept. These are all within the scope of the present invention.

In order that the objects, aspects and advantages of the application will become more apparent, the application will now be described in further detail with reference to the accompanying drawings and embodiments. It should be understood that the particular embodiments described herein are illustrative only and are not restrictive for the application.

It should be noted that, if not in conflict, the various features of the embodiments of the invention may be combined with one another without departing from scope of the present application. In addition, although the division of functional blocks is illustrated in a schematic diagram of an apparatus and a logical order is illustrated in a flowchart, in some cases, it can be different from the division of functional blocks in the device; or the steps shown or described may be performed other than that shown in the sequence of the flow chart.

Unless defined otherwise, all technical and scientific terms used in the specification have the same meaning as commonly understood by one of ordinary skill in the art to which this invention belongs. The terms used in the specification of the invention herein is for the purpose of describing particular embodiments only and is not intended to be limiting of the invention. As used herein, the term "and/or" includes any and all combinations of one or more of the associated listed items.

Furthermore, the technical features involved in the various embodiments of the present invention described below can be combined with each other as long as they do not conflict with each other.

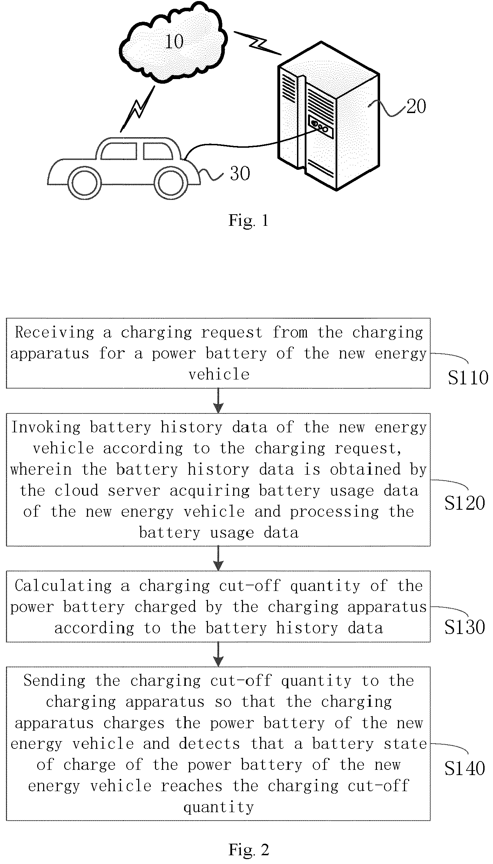

In order to solve the problem that the charging cut-off quantity cannot be set and adjusted according to different situations when a current new energy vehicle is charging, the embodiments of the present invention provide a method for acquiring a charging cut-off quantity, a device thereof, a new energy vehicle and a management system. Fig. 1 is a schematic view showing one application environment of a method for acquiring and setting a charging cut-off quantity according to an embodiment of the present invention. The application environment includes a cloud server 10, a charging apparatus 20 and a new energy vehicle 30.

The cloud server 10 is an upper computer or a server capable of being communicatively connected to the charging apparatus 20, and is capable of acquiring and managing charging data and automobile data uploaded by the charging apparatus 20. The cloud server 10 has the advantages of a large storage space, a large amount of historical data, multi-party data coexistence, and a strong processing power, etc. In addition, the cloud server 10 is capable of executing the method for acquiring a charging cut-off quantity provided by an embodiment of the present invention, and has a hardware structure of a module and a unit, etc.

The charging apparatus 20 can be electrically connected to the new energy vehicle 30 to charge the new energy vehicle 30, and can simultaneously charge one or more new energy vehicles 30. It can be provided in a user's private garage or parking space, or in a public parking space. For example, the charging apparatus can be a charging pile. Here, the charging apparatus 20 can acquire battery usage data and the battery history data of the new energy vehicle 30 during driving via a vehicle communication interface (VCI). At the same time, the charging apparatus 20 can also be communicatively connected to the cloud server 10, for example, via a network connection such as a local area network, the Internet, etc. Furthermore, the charging apparatus 20 can also upload the battery usage data and the battery history data to the cloud server 10, and/or acquire and execute an instruction issued by the cloud server 10, for example, executing the method for setting a charging cut-off quantity provided by an embodiment of the present invention. It has corresponding features such as a hardware structure of a module and a unit, etc.

The new energy vehicle 30 is capable of employing electrical energy as a power source, typically provided with one or more battery packs for providing electrical energy, and typically also provided with a battery management system (BMS) for monitoring and managing the battery packs. The battery management system (BMS) can be used for managing an electronic system of a rechargeable battery or battery pack. The system monitors state values of the battery, such as a voltage, a temperature, a current and a cooling liquid temperature, calculates state parameters of the battery, such as a state of charge, a state of health, a state of power and an insulation resistance, and reports these data to the outside through a certain communication mode. Meanwhile, the system also includes functions of battery thermal management, charge/discharge control, battery equilibrium, and so on. Further, the new energy vehicle 30 can also be electrically connected to the charging apparatus 20, and the battery usage data and battery history data during driving of the new energy vehicle 30 are sent to the charging apparatus 20 via a vehicle communication interface (VCI). The battery in the new energy vehicle 30 is supplemented with electrical energy by the charging apparatus 20.

In particular, the embodiments of the present invention will be further described with reference to the following drawings.

Embodiment I

The embodiment of the present invention provides a method for acquiring a charging cut-off quantity, which is applied to a cloud server, wherein the cloud server is communicatively connected to a charging apparatus which is electrically connected to a new energy vehicle. The cloud server can be the cloud server 10 in the above-mentioned application scenario. The charging apparatus can be the charging apparatus 20 in the above-mentioned application scenario. The new energy vehicle can be the new energy vehicle 30 in the above-mentioned application scenario. With reference to Fig. 2, a flow of a method for acquiring a charging cut-off quantity provided by an embodiment of the present invention is shown. The method includes, but is not limited to, the following steps:

Step S110, receiving a charging request from the charging apparatus for a power battery of the new energy vehicle.

In an embodiment of the present invention, the charging apparatus sends a charging request to the cloud server when a new energy vehicle is accessed and needs to be charged, and the cloud server receives the charging request of the charging apparatus to the power battery of the new energy vehicle and performs the calculation work of the charging cut-off quantity.

Step S120, invoking battery history data of the new energy vehicle according to the charging request, wherein the battery history data is obtained by the cloud server acquiring battery usage data of the new energy vehicle and processing the battery usage data.

Here, the battery usage data includes at least one of a state of charge (SOC), a depth of discharge (DOD), a state of power (SOP), a total voltage, a total current, and a temperature of the battery. The battery history data includes at least one of a state of health (SOH), a historical driving electric quantity lower limit value, and a historical driving electric quantity consumption range of the battery. In addition, according to the state of charge SOC of the battery, a percentage indicates a charging cut-off quantity of a current electric quantity level of the battery, and the charging facility stops charging when the actual state of charge SOC of the power battery reaches a set value of the charging cut-off state of charge reference value. The depth of discharge DOD of the battery represents a degree of single discharge of the battery, which is a percentage of the single discharge capacity and the total discharge capacity, and can be generally understood as the difference between the state of charge after one charge and before the next charge. The state of power SOP of the battery represents a maximum output charge/discharge power of the power battery under different conditions, such as different temperatures and states of charge, and is further divided into a maximum continuous power and a maximum pulse power. The state of health SOH of the battery indicates, as a percentage, a ratio of a total capacity at which the battery is currently fully charged to a rated capacity.

In an embodiment of the present invention, a battery management system (BMS) is further provided in the new energy vehicle, and the battery management system is electrically connected to the battery. The battery usage data of the new energy vehicle is the data acquired by the battery management system when the cloud server directly communicates with the new energy vehicle. Alternatively, the cloud server may also be communicatively connected to the charging apparatus, and the automobile data is acquired from the battery management system via the connection of the charging apparatus to the new energy vehicle. Further, the battery usage data may also be pre-stored in the cloud server, and the cloud server invokes the battery usage data stored in the storage medium when it is necessary to calculate the charging cut-off quantity.

Step S130, calculating a charging cut-off quantity of the power battery charged by the charging apparatus according to the battery history data.

In an embodiment of the present invention, based on the acquired battery usage data and battery history data of the battery in the new energy vehicle, the system may calculate a charging cut-off quantity of the battery, and issue an instruction to the charging apparatus, so that the charging apparatus can adjust the charging cut-off quantity of the current charging task of the new energy vehicle. When the charging apparatus charges the new energy vehicle, the charging electric quantity of the new energy vehicle does not exceed the charging cut-off quantity, so as to ensure charging safety while minimizing the loss of the battery.

Here, the charging cut-off quantity is a highest electric quantity that can be set for the charging apparatus to charge the new energy vehicle, and setting the charging cut-off quantity can ensure the charging safety of the power battery. After the system has set the charging cut-off quantity, when the charging apparatus charges the new energy vehicle, it stops charging the power battery so as to avoid a safety accident as the electric quantity of the power battery reaches the charging cut-off quantity. The setting of the charging cut-off quantity depends on the state of the power battery and the power consumption state of the new energy vehicle. The charging cut-off quantity can be calculated by the acquiring method provided by the embodiment of the present invention.

Step S140: sending the charging cut-off quantity to the charging apparatus so that the charging apparatus charges the power battery of the new energy vehicle and detects that a battery state of charge of the power battery of the new energy vehicle reaches the charging cut-off quantity.

In an embodiment of the present invention, after the cloud server calculates and obtains the charging cut-off quantity, the data is packaged and sent to the charging apparatus, so that the charging apparatus can perform charging work to charge the power battery of the new energy vehicle. During the charging process, the charging apparatus can detect the battery state of charge of the power battery of the new energy vehicle in real time. After the battery state of charge of the power battery of the new energy vehicle is greater than or equal to the charging cut-off quantity, the charging cut-off quantity is reached, and the charging needs to be stopped at this moment. Here, the battery state of charge (SOC) is a ratio of the remaining capacity of the power battery to the capacity of the power battery in a fully charged state, and is usually represented by a percentage, with the value range thereof of 0-1. When SOC = 0, it represents that the battery is completely discharged. When SOC = 1, it represents that the battery is completely filled.

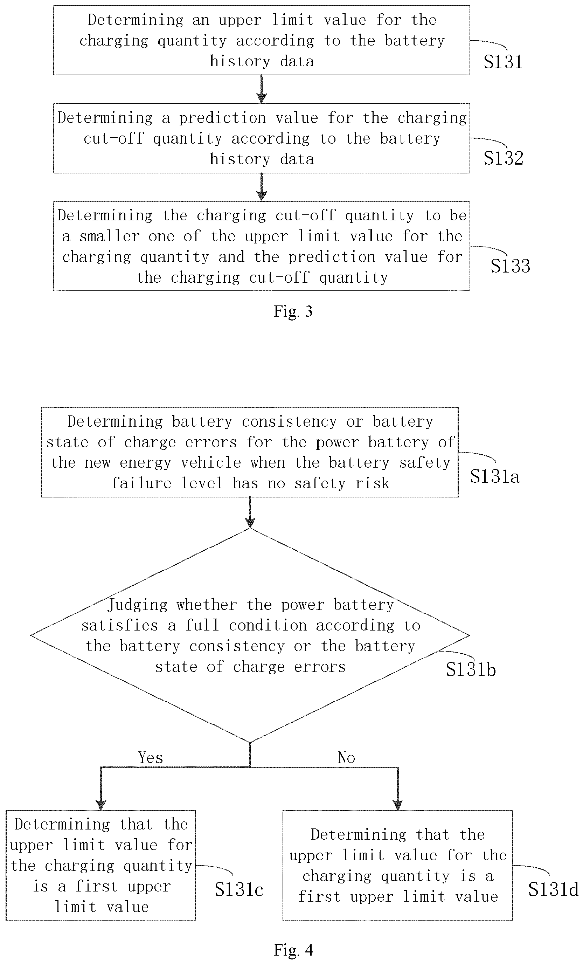

Further, in some embodiments, referring to Fig. 3, there is shown a sub-flow of Step S130 in the acquiring method shown in Fig. 2. The calculating a charging cut-off quantity of the power battery charged by the charging apparatus according to the battery history data includes, but not limited to the following steps:

Step S131, determining an upper limit value for the charging quantity according to the battery history data.

Here, the determining an upper limit value for the charging quantity according to the battery history data includes: determining a battery safety failure level of the power battery based on the battery history data; and determining an upper limit value for the charging quantity of the power battery charged by the charging apparatus according to the battery safety failure level.

In an embodiment of the present invention, the upper limit value for the charging quantity is a maximum chargeable electric quantity of a rechargeable battery determined according to a safety risk of the power battery. The charging electric quantity of the power battery controlled to be within the upper limit value for the charging quantity can ensure that the power battery is minimally affected by the safety risk. In the embodiment of the present invention, a smaller one of the upper limit value for the charging quantity and the prediction value for the charging cut-off quantity is selected as the charging cut-off quantity to ensure the charge safety of the power battery.

Specifically, when the intelligent setting system detects that the vehicle power battery has a safety fault or has a safety hidden danger in early warning, the upper limit value for the charging quantity should be reduced to avoid the power battery in a higher capacity state and reduce the risk of charging safety accidents. The determining a battery safety failure level of the power battery based on the battery history data can be determined according to the number and situation of safety faults already existing in the new energy vehicle or the number and situation of warning of potential safety hazards. Specifically, the battery safety failure level includes four safety fault levels of no safety risk, slight safety warning, less serious safety warning and serious safety warning. The situation where no safety hazard exists can be set as the no safety risk level. The situation where one safety hazard exists can be set as the slight safety warning level. The situation where there are two safety hazards can be set as the less serious safety warning level. The situation where there are three safety hazards can be set as the serious safety warning level, etc. For example, a slight safety warning level is determined when the state of health of the battery is poor. A less serious safety warning level is determined when the state of health of the battery is poor and the service life of the battery of the automobile is long (e.g. more than three years of use). Specifically, the conditions and the judgment method for determining the battery safety failure level of the power battery may be set according to actual needs, and need not be defined by the limitations of the embodiments of the present invention. Specifically, referring to Fig. 4, it shows a sub-flow of Step S131 in the acquiring method shown in Fig. 3. The determining an upper limit value for the charging quantity of the power battery charged by the charging apparatus according to the battery safety failure level includes:

Step S131a, determining battery consistency or battery state of charge errors for the power battery of the new energy vehicle when the battery safety failure level has no safety risk;

Step S131b, judging whether the power battery satisfies a full condition according to the battery consistency or the battery state of charge errors; if so, the process proceeds to Step S131c; if not, the process proceeds to Step S131d;

Step S131c, determining that the upper limit value for the charging quantity is a first upper limit value; and

Step S131d, determining that the upper limit value for the charging quantity is a second upper limit value, wherein the second upper limit value is less than the first upper limit value.

In the embodiment of the present invention, when the safety failure level is no safety risk, it is further judged whether the power battery satisfies the full condition. When it is detected that the battery consistency is good or the error of the state of charge SOC is small, it is determined that the power battery satisfies a condition under which the power battery can be fully charged and it is necessary to fully charge the power battery one or more times. Meanwhile, the upper limit value for the charging quantity can be determined as a first upper limit value. For example, the upper limit value $SOC_{uppper}$ for the charging quantity can be set as 100%. If it is determined that the power battery does not satisfy the condition under which the power battery can be fully charged if the battery consistency is poor or the battery state of charge error is large, it may be determined that the upper limit value for the charging quantity is a second upper limit value, wherein the second upper limit value is less than the first upper limit value. For example, the upper limit value $SOC_{uppper}$ for the charging quantity may be set to 98%. Here, a judgment condition for judging whether the condition under which the power battery can be fully charged is satisfied according to the battery consistency and the battery state of charge can be set according to the total electric quantity, type, material, etc. of the battery. For example, when the power battery is a lithium battery, and each parameter of each individual battery in the lithium battery pack is in a relatively small range, such as when the electric quantity is accurate to a consistent single digit, a state of good battery consistency can be determined. If the state of charge error of the battery is small, a specific value may be set. For example, a state in which the error is small can be set when the error is 1%. Specifically, the value may be set according to actual needs, without being limited to the embodiments of the present invention.

Furthermore, when the intelligent setting system is in a slight safety pre-warning, the upper limit value $SOC_{uppper}$ for the charging quantity can be set to 95%. When the intelligent setting system is in a serious safety pre-warning, the upper limit value $SOC_{uppper}$ for the charging quantity can be set to 93%. When the intelligent setting system is in a serious safety pre-warning, the upper limit value $SOC_{uppper}$ for the charging quantity can be set to 0%, and battery charging is not allowed at this time. Specifically, the setting method of the safety fault level, etc. can be a general setting method, and can also be adjusted according to different vehicles and different battery types in practical applications.

Step S132, determining a prediction value for the charging cut-off quantity according to the battery history data.

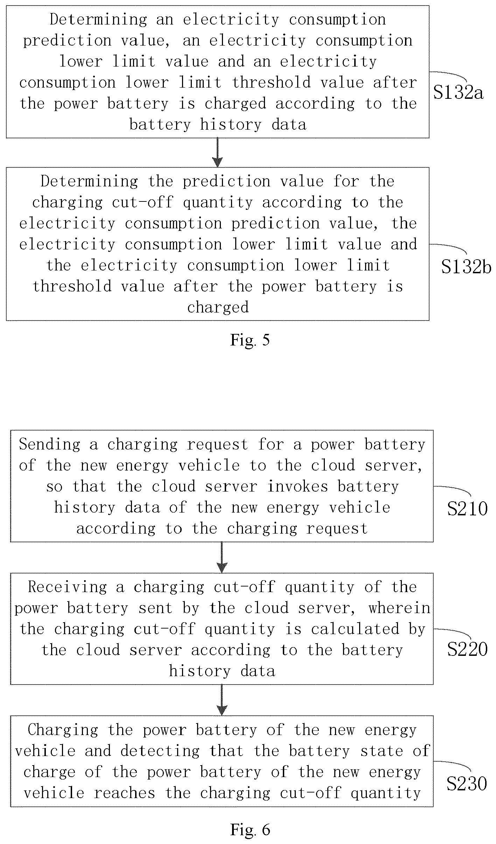

In the embodiment of the present invention, the electricity consumption prediction value and the electricity consumption lower limit threshold value can be determined according to the battery history data and the environmental data of the power battery use environment, so that the prediction value for the charging cut-off quantity can be determined. Specifically, referring to Fig. 5, a sub-flow of Step S132 in the acquiring method shown in Fig. 3 is shown. The determining a prediction value for the charging cut-off quantity according to the battery history data includes the following steps:

Step S132a, determining an electricity consumption prediction value, an electricity consumption lower limit value and an electricity consumption lower limit threshold value after the power battery is charged according to the battery history data.

In an embodiment of the present invention, the electricity consumption prediction value $SOC_{window}$ is a calculated total electric quantity by intelligent prediction that may be consumed during driving after this charging according to battery data, such as the state of charge of the power battery, the total voltage, the total current, the temperature, the electric power consumption of the vehicle, the state of health of the battery SOH, the lower limit of the electric quantity used in historical driving, and the range of the electric quantity used in historical driving. Further, since the output performance of the battery is reduced in a low-temperature environment, it also needs to consider for the prediction value of the driving charge consumption range the weather temperature for at least 24 hours, multiplied by a low-temperature coefficient $k_1$, $k_1 \geq 1$. The lower the temperature is, the greater the value of $k_1$ is.

In an embodiment of the present invention, the power battery can effectively extend the service life under the operating conditions of a small depth of discharge DOD, and the most suitable operating interval thereof is 40%-60%. In the embodiment of the present invention, combined with the influence of the current meteorological temperature, a lowest total electric quantity, namely, an electricity consumption lower limit value $SOC_{lower}$, which may be consumed in the safe state of the power battery during the driving of the user can be predicted according to the low temperature coefficient and the electricity consumption prediction value $SOC_{window}$. It at least needs to charge the new energy vehicle to the electric quantity above the electricity consumption lower limit value SOCiower so as to ensure that the power battery has sufficient electric quantity to complete the work. Furthermore, the prediction value for the charging cut-off quantity calculated according to the electricity consumption lower limit value can enable the power battery to work as far as possible in the most suitable working range. The calculation formula of the electricity consumption lower limit value $SOC_{lower}$ is as follows:

$$SOC_{lower} = 50\% - \frac{k_1 \cdot SOC_{window}}{2}$$

Specifically, the setting the battery driving electricity consumption lower limit threshold value according to the battery usage data and the battery history data includes: setting a lower limit threshold value of the driving electric quantity of the battery according to the number of times of acceleration, the amplitude of stepping on an accelerator, the number of times of mountain working conditions and/or low temperature working conditions during the driving of the new energy vehicle.

In the embodiment of the present invention, it can be seen from the state of power SOP characteristic of the power battery that when the state of charge SOC of the power battery is low, the discharge rate performance thereof will decrease, and the vehicle will have situations such as poor power performance, difficulty in climbing a slope, inability to raise the vehicle speed, and poor driving experience of the user. Therefore, it is also necessary to consider the driving habits of the user and the proportion of mountainous conditions in the daily driving route of the user. These factors are reflected in the discharge power of the power battery during driving, and the discharge power can be obtained from the synchronous change curve of the total voltage and the total current in the usage data. Therefore, it is also necessary to set the lowest total electric quantity, namely, the electricity consumption lower limit threshold value, that may be consumed by the power battery in a state where a user can normally complete a driving task, according to the driving habits of the user and the working condition of the new energy vehicle, so as to ensure that the new energy vehicle has sufficient electric quantity to complete the work.

Specifically, when the driving habits of the user includes more acceleration, heavy accelerator stepping, and more mountain working conditions, the maximum value of the discharge power of the battery in the driving process data is larger and the rate of change of the discharge power is larger. At this time, the intelligent setting system will increase the lower limit threshold $SOC_{buffer}$ of the driving electric quantity, $SOC_{buffer} \geq 0$. When there is less acceleration, light accelerator stepping or less mountain conditions in the driving habits of users, the maximum value of battery discharge power in the driving process data is smaller and the rate of change of discharge power is smaller. At this time, the intelligent setting system will reduce the lower limit threshold SOCbuffer of driving electric quantity, SOCbuffer $\geq$ 0.

Since the output performance of the battery is reduced in a low-temperature environment, the meteorological temperature within at least 24 hours should also be considered for the lower limit threshold value SOCbuffer of the driving electric quantity, multiplied by the low-temperature coefficient $k_2$, $k_2 \geq 1$. The lower the temperature is, the greater the value of $k_2$ is.

Step S132b, determining the prediction value for the charging cut-off quantity according to the electricity consumption prediction value, the electricity consumption lower limit value and the electricity consumption lower limit threshold value after the power battery is charged.

The the determining the prediction value for the charging cut-off quantity according to the electricity consumption prediction value, the electricity consumption lower limit value and the electricity consumption lower limit threshold value after the power battery is charged has a calculation formula as follows:

$$SOC_{pre} = k_1 SOC_{window} + SOC_{lower} + k_2 SOC_{buffer}$$

where $SOC_{pre}$ represents a prediction value for the charging cut-off quantity; $SOC_{window}$ represents an electricity consumption prediction value; $SOC_{lower}$ represents an electricity consumption lower limit value; SOCbuffer represents an electricity consumption lower limit threshold value; $k_1$ represents a low-temperature coefficient for the electricity consumption prediction value; and $k_2$ represents a low-temperature coefficient for the electricity consumption lower limit threshold value.

Step S133, determining the charging cut-off quantity to be a smaller one of the upper limit value for the charging quantity and the prediction value for the charging cut-off quantity.

After obtaining the prediction value $SOC_{pre}$ of the charging cut-off quantity, the smaller value of the prediction value of the charging cut-off quantity and the upper limit value of the charge electric quantity serves as the charging cut-off quantity SOCend:

$$SOC_{end} = \min(SOC_{uppper}, SOC_{pre})$$

The following Table 1 is a set of simulation data provided by an embodiment of the present invention, which includes battery history data for first 14 times stored by a vehicle, and the acquiring method provided by an embodiment of the present invention is capable of calculating and adjusting the next time, i.e. a charging cut-off quantity at a 15th time, and the same is applied to the charging apparatus that automatically stops charging when the vehicle reaches the cut-off quantity during charging. Furthermore, in this example, the vehicle has no safety risk, which does not satisfy the full conditions, SOCbuffer = 10%, $k_1$=1, and $k_2$ = 1.

Table 1

| Charge record | Driving electric quantity lower limit value $SOC_{lower}$ (%) | Electricity consumption range $SOC_{window}$ (%) | Charging cut-off quantity SOCend (%) |
|---|---|---|---|
| 1 | 38.8 | 43.6 | 82.4 |
| 2 | 32.8 | 43.2 | 76.0 |
| 3 | 42.8 | 32.0 | 74.8 |
| 4 | 14.4 | 61.2 | 75.6 |
| 5 | 16.8 | 57.6 | 74.4 |
| 6 | 31.2 | 56.0 | 87.2 |
| 7 | 21.2 | 50.0 | 71.2 |
| 8 | 26.4 | 60.8 | 87.2 |
| 9 | 25.6 | 52.4 | 78.0 |
| 10 | 34.0 | 52.4 | 86.4 |
| 11 | 27.2 | 43.6 | 70.8 |
| 12 | 34.4 | 52.0 | 86.4 |

(continued)

| Charge record | Driving electric quantity lower limit value $SOC_{lower}$ (%) | Electricity consumption range $SOC_{window}$ (%) | Charging cut-off quantity SOCend (%) |
|---|---|---|---|
| 13 | 22.4 | 65.6 | 88.0 |
| 14 | 31.2 | 51.2 | 82.4 |
| 15 (set value) | 28.6 | 62.8 | 91.4 |

Embodiment II

The embodiment of the present invention provides a method for setting a charging cut-off quantity, which is applied to a charging apparatus, wherein the charging apparatus is communicatively connected to a cloud server and electrically connected to a new energy vehicle. The cloud server can be the cloud server 10 in the above-mentioned application scenario. The charging apparatus can be the charging apparatus 20 in the above-mentioned application scenario. The new energy vehicle can be the new energy vehicle 30 in the above-mentioned application scenario. With reference to Fig. 6, a flow of a method for setting a charging cut-off quantity provided by an embodiment of the present invention is shown. The method includes, but is not limited to, the following steps:

Step S210, sending a charging request for a power battery of the new energy vehicle to the cloud server, so that the cloud server invokes battery history data of the new energy vehicle according to the charging request, wherein the battery history data is obtained by the cloud server acquiring battery usage data of the new energy vehicle and processing the battery usage data.

In an embodiment of the present invention, a battery management system and a battery are provided in the new energy vehicle. The battery management system is electrically connected to the battery. The new energy vehicle acquires, via the battery management system, battery usage data of the new energy vehicle during driving after each charging is completed. The charging apparatus can be connected to the new energy vehicle via a vehicle communication interface (VCI) so as to acquire the battery usage data of the new energy vehicle during driving, or the cloud server can also be directly communicatively connected to the new energy vehicle for directly reading the battery usage data of the new energy vehicle. The communication connection can be a wired connection or a wireless connection, and can be specifically set according to actual needs.

Step S220, receiving a charging cut-off quantity of the power battery sent by the cloud server, wherein the charging cut-off quantity is calculated by the cloud server according to the battery history data.

In an embodiment of the invention, after obtaining the battery usage data and the battery history data of the new energy vehicle by the acquiring method according to the above-mentioned Embodiment I, the cloud server calculates the charging cut-off quantity that can be charged when the current charging apparatus charges the new energy vehicle, and packages the charging cut-off quantity as an adjustment instruction and sends same to the charging apparatus.

Step S230, charging the power battery of the new energy vehicle and detecting that the battery state of charge of the power battery of the new energy vehicle reaches the charging cut-off quantity.

In an embodiment of the present invention, after receiving an adjustment instruction or a data packet of a charging cut-off quantity issued by the cloud server, the charging apparatus can set a current charging cut-off quantity, so that when the charging apparatus charges a new energy vehicle, the charging electric quantity of the new energy vehicle does not exceed the charging cut-off quantity, so as to ensure charging safety. Also, the loss of a battery is minimized.

Embodiment III

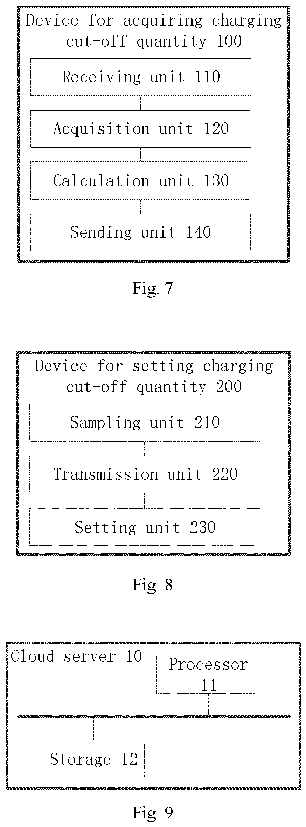

The embodiment of the present invention provides a device for acquiring a charging cut-off quantity, which is applied to a cloud server, wherein the cloud server is communicatively connected to a charging apparatus which is electrically connected to a new energy vehicle. The cloud server can be the cloud server 10 in the above-mentioned application scenario. The charging apparatus can be the charging apparatus 20 in the above-mentioned application scenario. The new energy vehicle can be the new energy vehicle 30 in the above-mentioned application scenario. With reference to Fig. 7, the structure of a device 100 for acquiring a charging cut-off quantity provided by an embodiment of the present invention is shown. The device 100 for acquiring the charging cut-off quantity includes a receiving unit 110, an acquisition unit 120, a calculation unit 130, and a sending unit 140.

The receiving unit 110 is configured for receiving a charging request from the charging apparatus for a power battery of the new energy vehicle.

The acquisition unit 120 is configured for invoking battery history data of the new energy vehicle according to the charging request, wherein the battery history data is obtained by the cloud server acquiring battery usage data of the new energy vehicle and processing the battery usage data.

The calculation unit 130 is configured for calculating a charging cut-off quantity of the power battery charged by the charging apparatus according to the battery history data.

The sending unit 140 is configured for sending the charging cut-off quantity to the charging apparatus so that the charging apparatus charges the power battery of the new energy vehicle and detects that a battery state of charge (SOC) of the power battery of the new energy vehicle reaches the charging cut-off quantity.

In some embodiments, the calculation unit 130 is further configured for determining an upper limit value for the charging quantity according to the battery history data; determining a prediction value for the charging cut-off quantity according to the battery history data; and determining the charging cut-off quantity to be a smaller one of the upper limit value for the charging quantity and the prediction value for the charging cut-off quantity.

In some embodiments, the calculation unit 130 is further configured for determining a battery safety failure level of the power battery based on the battery history data; and determining an upper limit value for the charging quantity of the power battery charged by the charging apparatus according to the battery safety failure level.

In some embodiments, the calculation unit 130 is further configured for determining battery consistency or battery state of charge errors for the power battery of the new energy vehicle when the battery safety failure level has no safety risk; judging whether the power battery satisfies a full condition according to the battery consistency or the battery state of charge errors; if so, determining that the upper limit value for the charging quantity is a first upper limit value; and if not, determining that the upper limit value for the charging quantity is a second upper limit value, wherein the second upper limit value is less than the first upper limit value.

In some embodiments, the calculation unit 130 is further configured for determining an electricity consumption prediction value, an electricity consumption lower limit value and an electricity consumption lower limit threshold value after the power battery is charged according to the battery history data; and determining the prediction value for the charging cut-off quantity according to the electricity consumption prediction value, the electricity consumption lower limit value and the electricity consumption lower limit threshold value after the power battery is charged.

In some embodiments, the calculation unit 130 is further configured for determining the electricity consumption prediction value and the electricity consumption lower limit threshold value according to the battery history data and the environment data of the power battery use environment.

In some embodiments, the determining the prediction value for the charging cut-off quantity according to the electricity consumption prediction value, the electricity consumption lower limit value and the electricity consumption lower limit threshold value after the power battery is charged has a calculation formula as follows:

$$SOC_{pre} = k_1 SOC_{window} + SOC_{lower} + k_2 SOC_{buffer}$$

where $SOC_{pre}$ represents a prediction value for the charging cut-off quantity; $SOC_{window}$ represents an electricity consumption prediction value; $SOC_{lower}$ represents an electricity consumption lower limit value; $SOC_{buffer}$ represents an electricity consumption lower limit threshold value; $k_1$ represents a low-temperature coefficient for the electricity consumption prediction value; and $k_2$ represents a low-temperature coefficient for the electricity consumption lower limit threshold value.

Embodiment IV

The embodiment of the present invention provides a device for setting a charging cut-off quantity, which is applied to a charging apparatus, wherein the charging apparatus is communicatively connected to a cloud server, and the charging apparatus is electrically connected to a new energy vehicle. The cloud server can be the cloud server 10 in the above-mentioned application scenario. The charging apparatus can be the charging apparatus 20 in the above-mentioned application scenario. The new energy vehicle can be the new energy vehicle 30 in the above-mentioned application scenario. With reference to Fig. 8, the structure of a device 200 for setting a charging cut-off quantity provided by the embodiment of the present invention is shown. The device 200 for setting the charging cut-off quantity includes a requesting unit 210, a receiving unit 220, and a setting unit 230.

The request unit 210 is configured for sending a charging request for a power battery of the new energy vehicle to the cloud server, so that the cloud server invokes battery history data of the new energy vehicle according to the charging request, wherein the battery history data is obtained by the cloud server acquiring battery usage data of the new energy vehicle and processing the battery usage data.

The receiving unit 220 is configured for receiving a charging cut-off quantity of the power battery sent by the cloud server, wherein the charging cut-off quantity is calculated by the cloud server according to the battery history data.

The setting unit 230 is configured for charging the power battery of the new energy vehicle and detecting that a battery state of charge of the power battery of the new energy vehicle reaches the charging cut-off quantity.

Embodiment V

An embodiment of the present invention also provides a cloud server 10. Referring to Fig. 9, it shows a hardware structure of a cloud server 10 capable of performing the method for acquiring the charging cut-off quantity of Figs. 2 to 5. The cloud server 10 may be the cloud server 10 shown in Fig. 1.

The cloud server 10 includes: at least one processor 11; and a storage 12 communicatively connected to the at least one processor 11, one processor 11 being exemplified in Fig. 8. The storage 12 stores instructions executable by the at least one processor 11, the instructions being executed by the at least one processor 11 to enable the at least one processor 11 to perform the method for acquiring the charging cut-off quantity described above with reference to Figs. 2 to 5. The processor 11 and the storage 12 may be connected via a bus or in other ways, the connection via a bus being exemplified in Fig. 9.

The storage 12 is a non-volatile computer-readable storage medium that can be used to store a non-volatile software program, a non-volatile computer-executable program, and modules, such as program instructions/modules corresponding to the method for acquiring the charging cut-off quantity in the embodiment of the present application, for example, each of the modules shown in Fig. 7. The processor 11 executes various functional applications of the cloud server and data processing by running a non-volatile software program, instructions and modules stored in the storage 12, i.e. realizing the method for acquiring the charging cut-off quantity of the above-mentioned method embodiment.

The storage 12 can include a program storage area and a data storage area, wherein the program storage area can store an operating system and an application program required by at least one function; and the storage data area may store data or the like created according to the use of the adjusting device of the charging cut-off quantity. In addition, the storage 12 may include high speed random access storage and may also include a nonvolatile storage, such as at least one magnetic disk storage device, a flash storage device, or other non-volatile solid state storage device. In some embodiments, the storage 12 may optionally include a storage remotely located with respect to the processor 11, which may be connected via a network to a charging cut-off quantity adjustment device. Examples of such networks include, but are not limited to, the Internet, intranets, local area networks, mobile communication networks, and combinations thereof.

The one or more modules are stored in the storage 12, and when executed by the one or more processors 11, perform the method for acquiring the charging cut-off quantity in any of the above-mentioned method embodiments, for example, perform the above-described method steps of Figs. 2 to 5, for realizing the functions of each module and each unit in Fig. 7.

The above-mentioned product can execute the method provided by the embodiments of the present application, and has corresponding functional modules and beneficial effects for executing the method. Details not described in detail in this embodiment can be found in the methods provided in the embodiments of this application.

The embodiments of the present application also provide a non-volatile computer-readable storage medium having stored thereon computer-executable instructions that are executed by one or more processors, for example, to perform the method steps of Figs. 2-5 described above to implement the functions of each of the modules in Fig. 7.

The embodiments of the present application also provide a computer program product including a computer program stored on a non-volatile computer-readable storage medium, the computer program including program instructions which, when executed by a computer, cause the computer to perform a method for acquiring a charging cut-off quantity in any of the method embodiments described above, for example, to perform the method steps of Figs. 2 to 5 described above to implement the functions of each of the modules in Fig. 7.

Embodiment VI

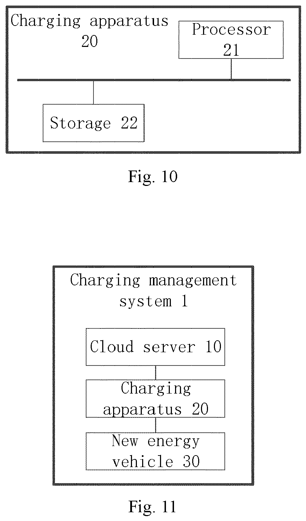

The embodiment of the present invention also provides a charging apparatus 20. Referring to Fig. 10, it shows a hardware stricture of a charging apparatus 20 capable of performing a method for setting the charging cut-off quantity described in Fig. 6. The charging apparatus 20 may be the charging apparatus 20 shown in Fig. 1.

The charging apparatus 20 includes: at least one processor 21; and a storage 22 communicatively connected to the at least one processor 21, one processor 21 being exemplified in Fig. 10. The storage 22 stores instructions executable by the at least one processor 21 to enable the at least one processor 21 to perform the method for setting the charging cut-off quantity described above with respect to Fig. 6. The processor 21 and the storage 22 may be connected via a bus or in other ways, the connection via a bus being exemplified in Fig. 10.

The storage 22 is a non-volatile computer-readable storage medium that can be used to store a non-volatile software program, a non-volatile computer-executable program, and modules, such as program instructions/modules corresponding to the method for setting the charging cut-off quantity in the embodiment of the present application, for example, each of the modules shown in Fig. 8. The processor 21 executes various functional applications of the server and data processing by running the non-volatile software programs, instructions and modules stored in the storage 22, i.e. realizing the method for setting the charging cut-off quantity of the above-described method embodiment.

The storage 22 can include a program storage area and a data storage area, wherein the program storage area can store an operating system and an application program required by at least one function; and the storage data area may store data or the like created according to the use of the adjusting device of the charging cut-off quantity. In addition, the storage 22 may include high speed random access storage and may also include a nonvolatile storage, such as at least one magnetic disk storage device, a flash storage device, or other non-volatile solid state storage device. In some embodiments, the storage 22 may optionally include a storage remotely located with respect to the processor 21, which may be connected via a network to a charging cut-off quantity adjustment device. Examples of such networks include, but are not limited to, the Internet, intranets, local area networks, mobile communication networks, and combinations thereof.

The one or more modules are stored in the storage 22, and when executed by the one or more processors 21, perform the method for setting the charging cut-off quantity in any of the above-mentioned method embodiments, for example, perform the above-described method steps of Fig. 6, for realizing the functions of each module and each unit in Fig. 8.

The above-mentioned product can execute the method provided by the embodiments of the present application, and has corresponding functional modules and beneficial effects for executing the method. Details not described in detail in this embodiment can be found in the methods provided in the embodiments of this application.

The embodiments of the present application also provide a non-volatile computer-readable storage medium having stored thereon computer-executable instructions that are executed by one or more processors, for example, to perform the method steps of Fig. 6 described above to implement the functions of each of the modules in Fig. 8.

The embodiments of the present application also provide a computer program product including a computer program stored on a non-volatile computer-readable storage medium, the computer program including program instructions which, when executed by a computer, cause the computer to perform a method for setting the charging cut-off quantity in any of the method embodiments described above, for example, to perform the method steps of Fig. 6 described above to implement the functions of each of the modules in Fig. 8.

Embodiment VII

The embodiment of the present invention provides a charging management system. Referring to Fig. 11, it shows a structure of a charging management system according to an embodiment of the present invention. The charging management system 1 includes a cloud server 10, a charging apparatus 20 and a new energy vehicle 30.

In an embodiment of the present invention, the cloud server 10 may be a cloud server 10 as described in the above-mentioned application scenario and/or embodiment 5. The charging apparatus 20 may be a charging apparatus 20 as described in the above-mentioned application scenario and/or embodiment 6. The new energy vehicle 30 may be a new energy vehicle 30 as described in the above-mentioned application scenario.

Here, the cloud server 10 can be communicatively connected to the charging apparatus 20 for calculating and acquiring a charging cut-off quantity of the power battery. The charging apparatus 20 can be electrically connected to the new energy vehicle 30, and is communicatively connected to the cloud server for charging a power battery of the new energy vehicle according to the charging cut-off quantity calculated by the cloud server and detecting that a battery state of charge (SOC) of the power battery of the new energy vehicle reaches the charging cut-off quantity. The structure and specific connection mode of the cloud server 10, the charging apparatus 20 and the new energy vehicle 30 can be seen from the above-mentioned embodiments, and will not be described in detail here.

The embodiments of the present invention provide a method for acquiring and setting a charging cut-off quantity, and a charging management system. In the system, a cloud server is communicatively connected to a charging apparatus, and the charging apparatus is communicatively connected to a new energy vehicle. The cloud server can acquire and invoke battery history data of the new energy vehicle according to a charging request of the charging apparatus for a power battery of the new energy vehicle, so as to calculate and obtain the charging cut-off quantity of the charging apparatus for the power battery, and send the charging cut-off quantity to the charging apparatus. The charging apparatus can perform charging and electric quantity monitoring on the power battery according to the charging cut-off quantity. The method provided by the embodiments of the present invention realizes intelligent calculation and setting of the charging cut-off quantity, which can effectively improve the power consumption and charging safety of the new energy vehicle, prolong the service life of the battery and reduce the driving safety risk of the user.

It should be noted that the embodiments of the device described above are merely schematic. The elements illustrated as separate components may or may not be physically separated. The components shown as elements may or may not be physical elements, i.e. may be located in one place, or may also be distributed over a plurality of network elements. Some or all of the modules may be selected to achieve the objectives of the embodiments according to actual needs.

From the above description of the embodiments, it will be clear to a person skilled in the art that the embodiments can be implemented by means of software plus a general purpose hardware platform, but also by means of hardware. It will be appreciated by those of ordinary skill in the art that implementing all or part of the flow of the methods of the embodiments described above can be accomplished by the hardware instructed by a computer program which can be stored on a computer-readable storage medium. The program, when executed, can include the flow of the embodiments of the methods described above. The storage medium may be a magnetic disk, an optical disk, a Read-Only storage (ROM) or a Random Access storage (RAM), etc.

Finally, it should be noted that the above embodiments are merely illustrative of the technical solutions of the present invention, rather than limiting it. Combinations of features in the above embodiments or in different embodiments are also possible within the spirit of the invention. The steps can be implemented in any order, and there are many other variations of the different aspects of the invention described above, which are not provided in detail for the sake of brevity. Although the invention has been described in detail with reference to the foregoing embodiments, those skilled in the art will appreciate that the technical solutions of the each above-mentioned embodiment can still be modified, or some of the technical features thereof can be equivalently substituted; and such modifications and substitutions will not cause the essence of the corresponding technical solutions to depart from the scope of the embodiments of the invention.

**Claims**

1. A method for acquiring a charging cut-off quantity, **characterized by** being applied to a cloud server, wherein the cloud server is communicatively connected to a charging apparatus which is communicatively connected to a new energy vehicle, the method comprising:

   receiving a charging request from the charging apparatus for a power battery of the new energy vehicle;
   invoking battery history data of the new energy vehicle according to the charging request, wherein the battery history data is obtained by the cloud server acquiring battery usage data of the new energy vehicle and processing the battery usage data;
   calculating a charging cut-off quantity of the power battery charged by the charging apparatus according to the battery history data; and
   sending the charging cut-off quantity to the charging apparatus so that the charging apparatus charges the power battery of the new energy vehicle and detects that a battery state of charge (SOC) of the power battery of the new energy vehicle reaches the charging cut-off quantity.

2. The acquiring method according to claim 1, **characterized in that** the calculating a charging cut-off quantity of the power battery charged by the charging apparatus according to the battery history data comprises:

   determining an upper limit value for the charging quantity according to the battery history data;
   determining a prediction value for the charging cut-off quantity according to the battery history data; and
   determining the charging cut-off quantity to be a smaller one of the upper limit value for the charging quantity and the prediction value for the charging cut-off quantity.

3. The acquiring method according to claim 2, **characterized in that** the determining an upper limit value for the charging quantity according to the battery history data comprises:

   determining a battery safety failure level of the power battery based on the battery history data; and
   determining an upper limit value for the charging quantity of the power battery charged by the charging apparatus according to the battery safety failure level.

4. The acquiring method according to claim 3, **characterized in that** the determining an upper limit value for the charging quantity of the power battery charged by the charging apparatus according to the battery safety failure level comprises:

   determining battery consistency or battery state of charge errors for the power battery of the new energy vehicle when the battery safety failure level has no safety risk;
   judging whether the power battery satisfies a full condition according to the battery consistency or the battery state of charge errors;

if so, determining that the upper limit value for the charging quantity is a first upper limit value; and

if not, determining that the upper limit value for the charging quantity is a second upper limit value, wherein the second upper limit value is less than the first upper limit value.

5. The acquiring method according to claim 2, **characterized in that** the determining a prediction value for the charging cut-off quantity according to the battery history data comprises:

determining an electricity consumption prediction value, an electricity consumption lower limit value and an electricity consumption lower limit threshold value after the power battery is charged according to the battery history data; and

determining the prediction value for the charging cut-off quantity according to the electricity consumption prediction value, the electricity consumption lower limit value and the electricity consumption lower limit threshold value after the power battery is charged.

6. The acquiring method according to claim 5, **characterized in that** the determining an electricity consumption prediction value, an electricity consumption lower limit value and an electricity consumption lower limit threshold value after the power battery is charged according to the battery history data comprises:

determining the electricity consumption prediction value and the electricity consumption lower limit threshold value according to the battery history data and the environment data of the power battery use environment.

7. The acquiring method according to claim 6, **characterized in that** the determining the prediction value for the charging cut-off quantity according to the electricity consumption prediction value, the electricity consumption lower limit value and the electricity consumption lower limit threshold value after the power battery is charged has a calculation formula as follows:

$$SOC_{pre} = k_1 SOC_{window} + SOC_{lower} + k_2 SOC_{buffer}$$

where $SOC_{pre}$ represents a prediction value for the charging cut-off quantity; $SOC_{window}$ represents an electricity consumption prediction value; $SOC_{lower}$ represents an electricity consumption lower limit value; $SOC_{buffer}$ represents an electricity consumption lower limit threshold value; $k_1$ represents a low-temperature coefficient for the electricity consumption prediction value; and $k_2$ represents a low-temperature coefficient for the electricity consumption lower limit threshold value.

8. A method for setting a charging cut-off quantity, **characterized by** being applied to a charging apparatus, wherein the charging apparatus is communicatively connected to a cloud server, and the charging apparatus is electrically connected to a new energy vehicle, the method comprising:

sending a charging request for a power battery of the new energy vehicle to the cloud server, so that the cloud server invokes battery history data of the new energy vehicle according to the charging request, wherein the battery history data is obtained by the cloud server acquiring battery usage data of the new energy vehicle and processing the battery usage data;

receiving a charging cut-off quantity of the power battery sent by the cloud server, wherein the charging cut-off quantity is calculated by the cloud server according to the battery history data; and

charging the power battery of the new energy vehicle and detecting that a battery state of charge of the power battery of the new energy vehicle reaches the charging cut-off quantity.

9. A cloud server, **characterized by** comprising:

at least one processor, and a storage communicatively coupled to the at least one processor;

wherein the storage stores instructions executable by the at least one processor, the instructions being executable by the at least one processor to enable the at least one processor to perform the method of any of claims 1-7.

10. A charging apparatus, **characterized by** comprising:

at least one processor, and a storage communicatively coupled to the at least one processor;

wherein the storage stores instructions executable by the at least one processor, the instructions being executable by the at least one processor to enable the at least one processor to perform the method of claim 8.

**11.** A charging management system, **characterized by** comprising:

the cloud server of claim 9 configured for calculating and acquiring a charging cut-off quantity of a power battery; and

the charging apparatus of claim 10, which is communicatively connected to the cloud server and electrically connected to a new energy vehicle, configured for charging a power battery of the new energy vehicle according to the charging cut-off quantity calculated by the cloud server and detecting that a battery state of charge (SOC) of the power battery of the new energy vehicle reaches the charging cut-off quantity.

Fig. 1

Receiving a charging request from the charging apparatus for a power battery of the new energy vehicle ⟩ S110

Invoking battery history data of the new energy vehicle according to the charging request, wherein the battery history data is obtained by the cloud server acquiring battery usage data of the new energy vehicle and processing the battery usage data ⟩ S120

Calculating a charging cut-off quantity of the power battery charged by the charging apparatus according to the battery history data ⟩ S130

Sending the charging cut-off quantity to the charging apparatus so that the charging apparatus charges the power battery of the new energy vehicle and detects that a battery state of charge of the power battery of the new energy vehicle reaches the charging cut-off quantity ⟩ S140

Fig. 2

Determining an upper limit value for the charging quantity according to the battery history data — S131

↓

Determining a prediction value for the charging cut-off quantity according to the battery history data — S132

↓

Determining the charging cut-off quantity to be a smaller one of the upper limit value for the charging quantity and the prediction value for the charging cut-off quantity — S133

Fig. 3

Determining battery consistency or battery state of charge errors for the power battery of the new energy vehicle when the battery safety failure level has no safety risk — S131a

↓

Judging whether the power battery satisfies a full condition according to the battery consistency or the battery state of charge errors — S131b

Yes / No

Determining that the upper limit value for the charging quantity is a first upper limit value — S131c

Determining that the upper limit value for the charging quantity is a first upper limit value — S131d

Fig. 4

18

Determining an electricity consumption prediction value, an electricity consumption lower limit value and an electricity consumption lower limit threshold value after the power battery is charged according to the battery history data

S132a

Determining the prediction value for the charging cut-off quantity according to the electricity consumption prediction value, the electricity consumption lower limit value and the electricity consumption lower limit threshold value after the power battery is charged

S132b

Fig. 5

Sending a charging request for a power battery of the new energy vehicle to the cloud server, so that the cloud server invokes battery history data of the new energy vehicle according to the charging request

S210

Receiving a charging cut-off quantity of the power battery sent by the cloud server, wherein the charging cut-off quantity is calculated by the cloud server according to the battery history data

S220

Charging the power battery of the new energy vehicle and detecting that the battery state of charge of the power battery of the new energy vehicle reaches the charging cut-off quantity

S230

Fig. 6

Device for acquiring charging
cut-off quantity 100

Receiving unit 110

Acquisition unit 120

Calculation unit 130

Sending unit 140

Fig. 7

Device for setting charging
cut-off quantity 200

Sampling unit 210

Transmission unit 220

Setting unit 230

Fig. 8

Cloud server 10

Processor 11

Storage 12

Fig. 9

Fig. 10

Fig. 11

EP 4 234 313 A1

| | Europäisches Patentamt |
|---|---|
| | European Patent Office |
| | Office européen des brevets |

# EUROPEAN SEARCH REPORT

Application Number

EP 22 20 5612

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2021/218073 A1 (DUAN XIAOHONG NINA [US] ET AL) 15 July 2021 (2021-07-15) | 1-3,5-11 | INV. B60L53/62 |
| Y | * paragraph [0001] - paragraph [0008]; claims 1, 9 * <br> * paragraph [0020] - paragraph [0044]; figure 1 * <br> * paragraph [0049] - paragraph [0058]; figures 2, 3 * | 4 | B60L53/65 <br> B60L53/68 <br> B60L58/13 <br> B60L3/00 |
| X | US 2013/285608 A1 (JIKIHARA TAKASHI [JP]) 31 October 2013 (2013-10-31) <br> * paragraph [0001] - paragraph [0007] * <br> * paragraph [0021] - paragraph [0039]; figures 1, 2 * <br> * paragraph [0040] - paragraph [0051]; figures 3, 4 * | 1-3,5, 8-11 | |
| X | US 2012/256588 A1 (HAYASHI MASANORI [JP] ET AL) 11 October 2012 (2012-10-11) <br> * paragraph [0002] - paragraph [0008] * <br> * paragraph [0040] - paragraph [0063]; figure 2 * <br> * paragraph [0075] - paragraph [0079]; figure 6 * | 1-3,5, 8-11 | TECHNICAL FIELDS SEARCHED (IPC) <br><br> B60L |
| Y | CN 110 221 222 A (FENGCHAO ENERGY TECH CO LTD) 10 September 2019 (2019-09-10) <br> * paragraph [0001] - paragraph [0006]; claim 1 * <br> * paragraph [0052] - paragraph [0065] * | 4 | |
| Y | CN 114 050 633 A (SHANGHAI MAKESENS ENERGY STORAGE TECH CO LTD) 15 February 2022 (2022-02-15) <br> * paragraph [0001] - paragraph [0003] * <br> * paragraph [0041] - paragraph [0050] * | 4 | |

The present search report has been drawn up for all claims

| Place of search | Date of completion of the search | Examiner |
|---|---|---|
| The Hague | 6 July 2023 | Utz, Tilman |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 22 20 5612

This annex lists the patent family members relating to the patent documents cited in the above-mentioned European search report.
The members are as contained in the European Patent Office EDP file on
The European Patent Office is in no way liable for these particulars which are merely given for the purpose of information.

06-07-2023

| Patent document cited in search report | | Publication date | Patent family member(s) | | Publication date |
|---|---|---|---|---|---|
| US 2021218073 | A1 | 15-07-2021 | CN 113103923 A | | 13-07-2021 |
| | | | DE 102021100163 A1 | | 15-07-2021 |
| | | | US 2021218073 A1 | | 15-07-2021 |
| | | | US 2022376313 A1 | | 24-11-2022 |
| US 2013285608 | A1 | 31-10-2013 | EP 2662949 A1 | | 13-11-2013 |
| | | | JP 5854287 B2 | | 09-02-2016 |
| | | | JP WO2012093638 A1 | | 09-06-2014 |
| | | | US 2013285608 A1 | | 31-10-2013 |
| | | | WO 2012093638 A1 | | 12-07-2012 |
| US 2012256588 | A1 | 11-10-2012 | JP 2012228165 A | | 15-11-2012 |
| | | | US 2012256588 A1 | | 11-10-2012 |
| CN 110221222 | A | 10-09-2019 | NONE | | |
| CN 114050633 | A | 15-02-2022 | CN 114050633 A | | 15-02-2022 |
| | | | CN 114389336 A | | 22-04-2022 |
| | | | US 2023207905 A1 | | 29-06-2023 |
| | | | US 2023208178 A1 | | 29-06-2023 |

EPO FORM P0459

For more details about this annex : see Official Journal of the European Patent Office, No. 12/82